**Europäisches Patentamt**

**European Patent Office**

**Office européen des brevets**

(19)

(11) Numéro de publication : **0 080 425**
**B1**

## FASCICULE DE BREVET EUROPÉEN

(12)

(45) Date de publication du fascicule du brevet :
13.12.89

(51) Int. Cl.⁴ : **G 01 R 31/00**, B 60 Q 11/00

(21) Numéro de dépôt : 82420161.0

(22) Date de dépôt : 24.11.82

(54) **Dispositif de commande, de sécurité et de diagnostic pour circuit électrique de véhicule.**

(30) Priorité : 25.11.81 FR 8122454

(43) Date de publication de la demande :
01.06.83 Bulletin 83/22

(45) Mention de la délivrance du brevet :
13.12.89 Bulletin 89/50

(84) Etats contractants désignés :
AT BE CH DE FR GB IT LI LU NL SE

(56) Documents cités :
DE—A— 2 843 194
FR—A— 2 435 725
US—A— 4 068 216
ELECTRONICS, vol. 52, n 18, août 1979, pages 69-70 ;
J. GOSCH : "On-board multiplexing system checks car's lights automatically".

(73) Titulaire : **RENAULT VEHICULES INDUSTRIELS**
**Société dite:**
**129 Rue Servient**
**F-69003 Lyon (FR)**

(72) Inventeur : **Sibeud, Jean-Paul**
**Hameau Sous Vigne Chaponnay**
**F-69360 Saint Symphorien d'Ozon (FR)**

(74) Mandataire : **Saint Martin, René et al**
**Régie Nationale des Usines Renault 8 & 10, avenue**
**Emile Zola**
**F-92109 Boulogne Billancourt (FR)**

**Description**

L'invention s'applique aux circuits électriques sur véhicules automobiles dont la surveillance de bon fonctionnement est un facteur de sécurité de circulation.

Les risques de court-circuit des circuits d'éclairage sont importants du fait de la dispersion géographique des appareils commandés sur le véhicule.

Les dispositifs connus à ce jour ne comportent généralement que les caractéristiques suivantes :

— la commande est obtenue par un interrupteur manœuvré par l'utilisateur. Cette commande est soit directe, soit indirecte, c'est-à-dire agit par l'intermédiaire d'un relais électromagnétique sur le circuit de puissance ;

— la sécurité est obtenue par des fusibles en série ou par un disjoncteur thermique. Dans certains cas, aucune sécurité n'est prévue ;

— la signalisation de défauts est obtenue par voyant répétiteur dans certains cas (indicateurs direction). La vérification des circuits coupés peut aussi être obtenue pendant la période de repos de ces circuits en y faisant circuler un très faible courant.

Le brevet FR-A-24 35 725 décrit un dispositif selon le préambule de la revendication principale et qui n'assure pas une surveillance suffisante.

La présente invention concerne un dispositif qui assure une surveillance permanente par un microprocesseur programmé de telle sorte qu'il puisse émettre des ordres, en contrôler l'exécution et déclencher en fonction du résultat de l'exécution une procédure adaptée aux circonstances.

Ce dispositif utilise des transistors dits « MOS de puissance » qui ont les avantages techniques suivants :

— faible puissance de commande (très grand gain de puissance) compatible avec les sorties du calculateur ;
— limitation en courant par la tension de commande (Vgs) ;
— possibilité démontage en parallèle de plusieurs transistors sans précautions ;
— très bon comportement aux surtensions ;
— très bon comportement aux températures élevées.

L'association des microprocesseurs, des transistors de puissance MOS et d'un logiciel utilisant rationnellement les possibilités de ces composants constituent la base de l'invention.

L'invention a pour but de :

— conserver la possibilité de commander la mise sous tension ou l'isolement d'un circuit quel que soit son état, et ceci sans altération des composants de l'installation,

— détecter l'état du circuit commandé qui peut être : normal, coupé, ou court-circuité,

— signaler l'état du circuit par un moyen simple permettant de discerner : s'il fonctionne normalement, s'il est coupé, s'il est court-circuité.

Ceci peut être obtenu par un voyant à éclairage constant ou clignotant selon des séquences différentes :

— exercer une action de sécurité consistant à : limiter le courant et à isoler et tester périodiquement le circuit en court-circuit. On évite ainsi : la détérioration du circuit et de ses composants. On ne paralyse pas inutilement un circuit présentant des courts-circuits aléatoires. Dès que le court-circuit disparaît, l'alimentation normale est rétablie ;

— en corollaire, nous faisons apparaître la nécessité de limitation du courant maximum, avec les avantages de protection qu'elle apporte pour les filaments de lampes à incandescence (réduction des chocs thermiques) et les moteurs électriques sont automatiquement à limitation de couple maximum, d'accélération maximale et d'échauffement induit bloqué ;

Le dispositif selon l'invention permet une surveillance permanente des circuits par un processeur et la réalisation d'une commande séquentielle dont le principal avantage est de réduire le nombre des commandes au tableau de bord et de simplifier la construction, la réparation et l'utilisation du véhicule.

Les applications du dispositif ne se limitent pas au système d'éclairage ; au contraire, tous les moteurs électriques auxiliaires du véhicule peuvent être commandés selon ce procédé qui, par sa détection des courts-circuits et sa limitation du courant maximum, évite la surchauffe des moteurs alimentés lorsque leur arbre est mécaniquement bloqué. Ceci permet de supprimer les protections électriques habituelles : contacts fin de course ou mécaniques, limiteur de couple.

Le dispositif comprend au moins un circuit de surveillance qui groupe :

a) — une source de courant continu ;

b) — un transistor de puissance, monté en série entre la source de courant et au moins l'un des appareils électriques d'utilisation ;

c) — une logique programmée pour tester périodiquement la conduction du transistor et la chute de tension dans la charge ;

d) — un système d'affichage ;

et il est caractérisé en ce que la logique est un microprocesseur et le transistor de puissance un transistor MOS dont la grille est pilotée par le microprocesseur, que le dispositif comprend des moyens ($E_p$) associés au microprocesseur pour mesurer la différence du potentiel drain-source dans le transistor MOS, la limitation d'intensité $I_{DS}$ à $I_{SAT}$ défileur correspondant à l'intensité nominale normale d'utilisation du ou des appareils électriques, $V_{GS}$ étant la tension de commande qui opère la limitation en courant et que le microprocesseur est programmé pour tester périodiquement la relation logique :

$$V_{GS} \neq 0$$

et

$$V_{DS} > 1/2\ V_{BAT}$$

où :

— $V_{DS}$ est la chute de tension dans le transistor MOS ;

— $V_{BAT}$ est la tension nominale aux bornes de la source de courant, le fait que cette relation logique soit satisfaite étant considéré comme caractérisant l'existence d'un court-circuit dans l'installation.

Le dessin annexé, donné à titre d'exemple non limitatif, permettra de mieux comprendre les caractéristiques de l'invention.

Figure 1 représente schématiquement les caractéristiques de fonctionnement d'un transistor de puissance du type « MOS ».

Figure 2 représente un circuit sur lequel l'invention permet de détecter un court-circuit en aval du transistor MOS de puissance.

Figure 3 illustre un circuit selon l'invention appliqué à la commande, au contrôle, et à la protection d'un éclairage sur véhicule.

Figure 4 représente une variante analogue à Figure 3, mais dans laquelle un microprocesseur peut dialoguer avec d'autres calculateurs du véhicule.

Figure 5 groupe des graphiques expliquant dans le temps le fonctionnement normal du dispositif.

Figure 6 est un ensemble de graphiques analogues illustrant le cas d'un court-circuit.

Figure 7 est un graphique analogue illustrant le cas d'une coupure du circuit.

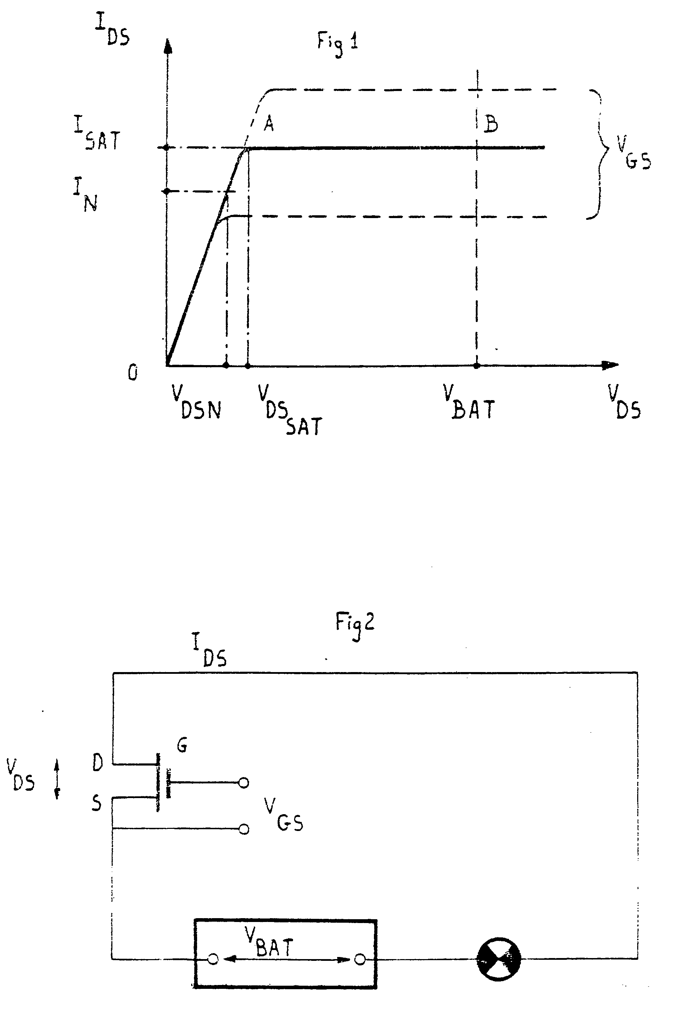

L'interrupteur est réalisé à l'aide d'un transistor de puissance du type MOS. La figure 1 illustre les caractéristiques de ce dispositif et montre un schéma de commande d'un circuit comportant le transistor MOS, une lampe à incandescence et une batterie d'accumulateurs.

La tension VGS est déterminée pour que la caractéristique du transistor conduisant soit représentée par O AB.

Le courant maximum que peut alors conduire ce transistor est $I_{SAT}$, correspondant au segment AB. La valeur de $I_{SAT}$ a été choisie supérieure à $I_n$ : courant nominal de la lampe de telle sorte qu'en fonctionnement normal, la chute de tension dans le transistor soit très faible et égale à $VDS_N$ provoquant une dissipation de puissance faible $P_N = I_N \times VDS_N$.

En cas de court-circuit, le courant conduit par le transistor ne peut dépasser $I_{SAT}$, le circuit aval est donc protégé. La puissance dissipée dans le transistor est alors : $P_{CC} = I_{SAT} \times V_{BAT}$, valeur élevée. Le transistor doit être choisi pour supporter cette puissance sans dommage. Un radiateur important serait nécessaire si cette puissance de court-circuit devait être dissipée pendant une longue durée. Mais dans le système inventé, nous allons voir que ce n'est pas le cas.

Pour la détection de l'état de court-circuit en aval du transistor MOS de puissance, on procède comme indiqué sur la figure 2.

Si VGS est différent de zéro, le transistor est conducteur, et la tension $V_{DS}$ doit être égale ou inférieure à $V_{DSN}$ (valeur explicitée sur la figure 1). Dans le cas où $V_{DS}$ est plus grande que $V_{DSN}$, par exemple si $VDS > 1/2\ V_{BAT}$, il est évident que la résistance d'utilisation alimentée à travers le transistor présente une résistance anormalement basse. La réunion de :

$$V_{GS} \neq 0 \quad et \quad V_{DS} > 1/2\ V_{BAT}$$

est le symptôme d'un court-circuit que notre microprocesseur convenablement programmé saura reconnaître en testant périodiquement la relation logique :

$$V_{GS} \neq 0 \quad et \quad V_{DS} > 1/2\ V_{BAT}$$

On notera :

— VGS est un ordre émis par le microprocesseur, et de ce fait, il n'est pas nécessaire de renouveler au microprocesseur l'information $V_{GS} \neq 0$.

3

— $V_{DS} > 1/2\ V_{BAT}$ est une mesure électrique nécessitant peu de précision et ne justifie pas une conversion analogique numérique toujours onéreuse en matériel. Une entrée logique du microprocesseur associée à un pont diviseur ou à une diode Zener est suffisante pour obtenir l'information :

$$V_{DS} > 1/2\ V_{BAT}$$

— sur la figure 2, les polarités de la batterie d'accumulateurs n'ont pas été représentées volontairement, parce que le transistor MOS peut être de type P ou de type N et ceci permet les deux montages possibles sur véhicule + ou — de la source d'énergie reliée au châssis.

Particularité de l'allumage d'une lampe à incandescence :

La résistance interne de la lampe lorsqu'elle est froide, est très basse, et sans précaution le système décrit détecterait un court-circuit à chaque allumage. Lorsque le microprocesseur émet un ordre d'allumage pour un circuit alimentant une lampe à incandescence, la périodicité du test logique de court-circuit sera allongée pour la seule période successive à l'ordre d'allumage et ceci pour le seul circuit concerné par l'événement d'allumage.

Un éventuel court-circuit serait détecté à la fin de cette période allongée.

Action du système lors de la détection d'un court-circuit :

Lorsqu'un court-circuit a été détecté, la commande $V_{GS}$ du transistor MOS de puissance est annulée pendant une durée T par le microprocesseur. Au bout de T, un ordre d'allumage sera émis de nouveau (si une consigne d'allumage est toujours présente).

Deux cas sont possibles :

— le court-circuit persiste : il est détecté et une nouvelle coupure de durée T est lancée. Des tentatives d'allumage seront lancées tant que la consigne d'allumage sera présente. Le rapport cyclique de la période de test allongée spécifique à l'allumage avec la durée T est établi en fonction de la puissance moyenne que peut dissiper normalement le transistor MOS de puissance dans le contexte technologique de la réalisation ;

— le court-circuit a disparu : le fonctionnement redevient normal avec test périodique de la présence d'un éventuel court-circuit. Cette disposition permet d'assurer la protection du circuit et de rétablir le fonctionnement correct dès que l'incident disparaît.

Il est fréquent qu'un court-circuit soit produit par l'intervention d'un réparateur, par le contact fugitif sous l'effet d'un choc d'éléments conducteurs du circuit, par la présence temporaire d'un liquide conducteur.

La limitation du courant de court-circuit qui est une particularité de l'invention évite les phénomènes de soudage des pièces en contact, que l'on constate habituellement dans les circuits mal protégés. La possibilité du système de tester systématiquement la présence du court-circuit présente l'avantage, compte tenu des conditions sus-mentionnées, d'offrir une plus grande sûreté de conservation du fonctionnement de l'organe commandé, et par là, d'améliorer la sécurité du véhicule.

Détection des coupures de circuit, soit de la ligne, soit du récepteur, par exemple le filament d'une lampe :

Le microprocesseur est programmé pour interrompre pendant un temps très court et périodiquement la tension $V_{GS}$ permettant la conduction du transistor MOS de puissance (voir figure 2).

Si $V_{GS} = 0$, on doit avoir $V_{DS} = V_{BAT}$, à condition que le drain D du transistor soit relié à la batterie à travers la ligne et le récepteur (une lampe, dans le cas de la figure 2).

Si le récepteur ou la ligne sont coupés, on n'obtiendra pas $V_{DS} = V_{BAT}$.

Comme dans le cas de détection du court-circuit, il est possible de se contenter de constater que $V_{DS} > 1/2\ V_{BAT}$, mais en s'intéressant à l'information complémentaire qui signifiera dans une approximation qui nous est suffisante $V_{DS} < 1/2\ V_{BAT}$.

Si la réunion $V_{GS} = 0$ et $V_{DS} < 1/2\ V_{BAT}$ est vérifiée, on aura diagnostiqué une coupure du circuit.

Remarque : une possibilité existe : elle consiste à mesurer $V_{DSN}$ qui est nulle si le circuit est coupé, parce que $I_{DS} = 0$ ; si on a $V_{GS} \neq 0$ et $V_{DS} = 0$, une coupure du circuit existe. L'acquisition de $V_{DS} = 0$ est délicate et nécessite un circuit plus complexe et donc plus onéreux que celui correspondant à l'option décrite. Nous signalons cependant cette disposition que l'on adopterait si les parasites radio-électriques générés par le système décrit devaient, pour des applications particulières, provoquer des difficultés.

Le système décrit s'applique à des récepteurs du type résistance pure. Dans le cas de charges inductives, le test de coupure du circuit produirait périodiquement des surtensions. Il est possible de remédier à cet inconvénient à l'aide de plusieurs dispositifs que l'on branchera entre drain et source du transistor de puissance MOS et en respectant les polarités imposées par le type de transistor MOS qui peut être P ou N selon le pôle de la batterie relié au commun.

— Circuit composé d'une résistance et d'un condensateur en série.
— Diode de barrage.
— Diode de barrage + diode Zener (cette disposition permet de conserver la rapidité de la décroissance du courant en limitant la surtension à une valeur admissible).
— Varactor ou dispositif analogue.

Le choix de ces dispositifs est un problème technologique et économique, dont la solution peut évoluer dans le temps.

Ces dispositifs n'ont pas été dessinés sur les figures, parce que leur représentation est polarisée pour deux d'entre eux et que nous avons voulu garder une représentation générale couvrant les deux possibilités de montage possible. Il est évident pour l'homme de l'art de placer correctement ces dispositifs.

Information de l'état de fonctionnement des circuits commandés :

On a décrit la procédure de détection par le microprocesseur des états suivants :

— court-circuit ;
— coupure du circuit.

L'état normal du circuit commandé est la réunion des informations NI court-circuit ET Ni circuit coupé qu'il est aisé d'obtenir par programmation adéquate du microprocesseur.

Ces états peuvent être signalés par un simple voyant fonctionnant selon la procédure suivante :

— voyant éclairé : fonctionnement normal du circuit commandé ;
— voyant clignotant rapidement : circuit commandé, mais court-circuit ;
— voyant clignotant lentement : circuit commandé, mais circuit coupé.

Le conducteur peut être ainsi informé de l'état d'exécution des commandes qu'il a émises.

Ces informations peuvent évidemment être exploitées dans tout dispositif installé sur le véhicule.

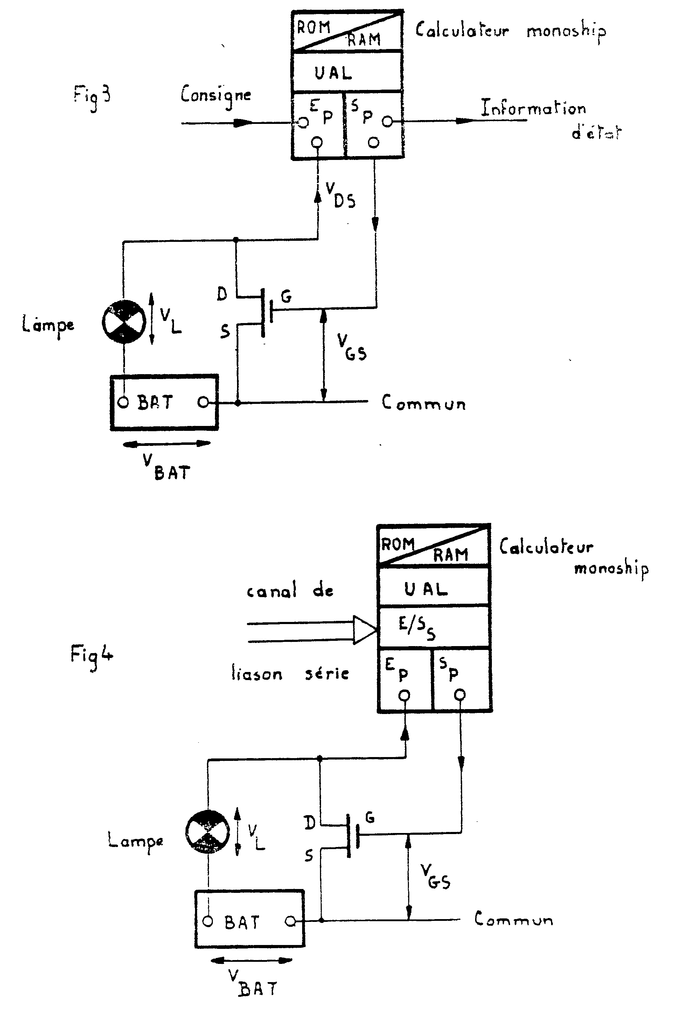

La figure 3 montre le procédé appliqué à la commande, au contrôle, et à la protection d'un éclairage sur véhicule.

Cette disposition s'applique à une réalisation ne comportant qu'un seul calculateur monochip.

Le calculateur ou microprocesseur complet est constitué :

| | |
|---|---|
| — par une mémoire de programme « savoir faire » | ROM |
| — par une mémoire temporaire de travail | RAM |
| — par une unité arithmétique et logique (microprocesseur) | UAL |
| — par une interface d'entrées parallèles | Ep |
| — par une interface de sorties parallèles | Sp |

Pour traiter le cas d'un seul récepteur, il est nécessaire de disposer de :
— deux entrées parallèles :

— une entrée consigne = ordre émis par le pilote du véhicule à l'aide d'un interrupteur
— une entrée de détection de $V_{DS} > 1/2\ V_{BAT}$
— deux sorties parallèles :
— une commande pour le transistor MOS : $V_{GS}$
— une information sur voyant d'état destinée au pilote.

Variante :

Dans le cas où N récepteurs devraient être commandés par le même interrupteur selon une procédure séquentielle ; le nombre d'entrées/sorties s'établirait de la manière suivante :

— entrées :
— deux commandes : progression et régression
— N entrées de détection $V_{DS} > 1/2\ V_{BAT}$

soit un total de N + 2 entrées parallèles
— sorties : deux cas possibles :
— informations contrôle retour individuelles
N contrôles
N commandes $V_{GS}$ de transistor MOS
soit 2 N sorties
— information contrôle retour collective
1 contrôle
N commandes $V_{GS}$ de transistor MOS
soit (N + 1) sorties.

(Voir Tableau page 6)

Pour N récepteurs, le tableau suivant résume les E/S :

| Commande | Informations de contrôle individuelles | | Informations de contrôle collectives | |
|---|---|---|---|---|
| | E | S | E | S |
| Individuelle | 2 N | 2 N | 2 N | N + 1 |
| Séquentielle | N + 2 | 2 N | N + 2 | N + 1 |

On remarque que le calculateur ou microprocesseur monochip nécessaire à la réalisation de l'invention peut être mieux utilisé par l'adoption de commandes séquentielles pas à pas toutes les fois que cette disposition est compatible avec l'application traitée (éclairage du véhicule, essuie-vitres à plusieurs vitesses, ralentisseur électrique, etc.)

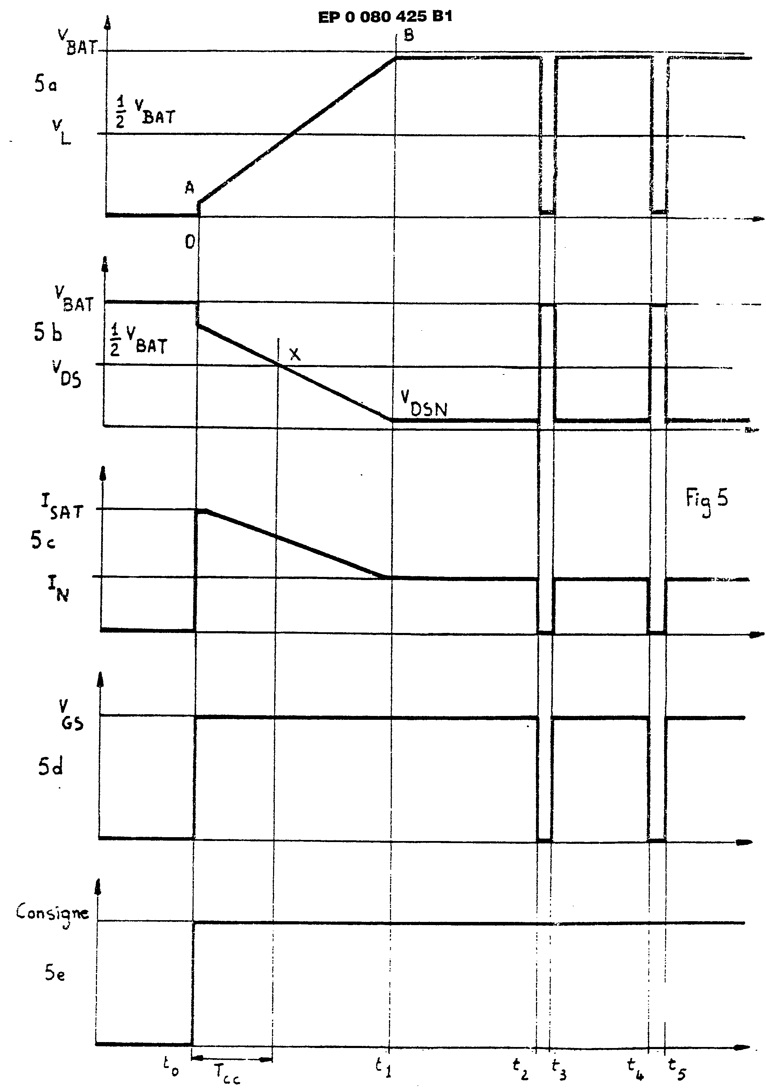

La figure 4 ne diffère de la figure 3 que par le microprocesseur utilisé qui est aussi un monochip, mais possédant en plus une interface d'entrée sortie série lui permettant de dialoguer avec les autres calculateurs installés sur le véhicule.

Le système décrit devient ainsi un système ouvert périphérique d'un ensemble plus vaste.

Dans ce cas, pour N récepteurs, les entrées et sorties parallèles seraient :

| Récepteur | Entrées | Sorties |
|---|---|---|
| N | N | N |

Dans le cadre de l'évolution des équipements électroniques de véhicule, on peut passer de la solution de la figure 3 à la solution de la figure 4.

Le fonctionnement en cas normal s'effectue comme illustré sur la figure 5, à savoir :

Le graphique 5 représente en fonction du temps l'apparition de la consigne d'allumage de la lampe à partir de t0.

Le graphique 5d représente en fonction du temps la commande du transistor MOS de puissance émise par le microprocesseur. On note les interruptions de $t_2$ à $t_3$ et de $t_4$ à $t_5$, séparées par la période de récurrence $t_3$ à $t_4$, qui permettent de diagnostiquer les coupures éventuelles du circuit.

Le graphique 5c représente le courant dans le circuit qui est limité à $I_{SAT}$ à t0, mise sous tension de la lampe, par la caractéristique du transistor MOS de puissance. Au bout d'un intervalle de temps de $t_0$ à $t_1$, le filament de la lampe ayant pris sa température d'équilibre, le courant se fixe à sa valeur nominale : $I_N < I_{SAT}$.

Enfin, lors des tests de circuit coupé, le courant est annulé pendant la durée $t_2$ à $t_3$.

On a choisi $t_3 \sim t_2$ et $t_4 - t_3$, de sorte que la valeur moyenne du courant soit très peu affectée et qu'aucun clignotement ne puisse être décelé, même pour la lampe de plus faible inertie thermique.

Le graphique 5b représente la tension $V_{DS}$ du transistor MOS de puissance.

Elle permet les calculs de puissance et énergie dissipée. Elle est le complément de la figure 5a. Le test de court-circuit est effectué au premier allumage en $T_{cc}$, après $t_0$, lorsqu'en X :

$$V_{DS} < 1/2 \ V_{BAT}.$$

On note que $V_{DSN}$ est une fraction de Volt.

Ceci est une particularité du transistor MOS qui est très favorable à la conservation des performances du récepteur et aussi permet de réduire les dimensions des radiateurs nécessités par les transistors commutateurs.

Le graphique 5a représente la tension aux bornes de la lampe en fonction du temps.

On remarque :

En $t_0 \ V_L = I_{SAT} \times R_F$, avec $R_F$ résistance à froid du filament de la lampe.

De A vers B, le filament de la lampe tend vers sa température d'équilibre de fonctionnement.

Les tests de circuit coupé apparaissent comme des annulations de $V_L$ quand le circuit n'est pas coupé.

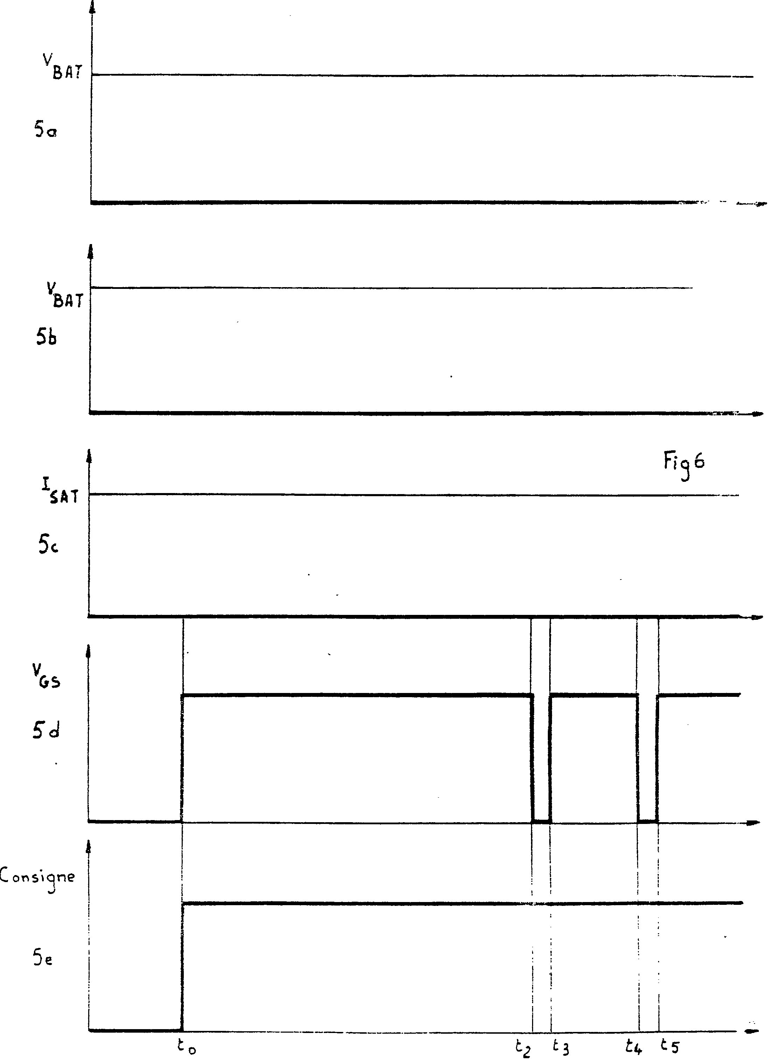

Dans le cas d'un court-circuit, le fonctionnement est illustré sur la figure 6

On remarque :

5a : pendant la période de test d'allumage, la tension $V_L$ atteint une valeur faible définie par la résistance du court-circuit et le courant de saturation du transistor MOS.

Au bout du temps $T_{cc}$, on a toujours $V_{DS} > 1/2 \, V_{BAT}$, le court-circuit est détecté et on annule $V_{GS}$ et par suite $I_{SAT}$.

Au bout d'une certaine durée et si la consigne d'allumage 5e est toujours active, on testera à nouveau le circuit.

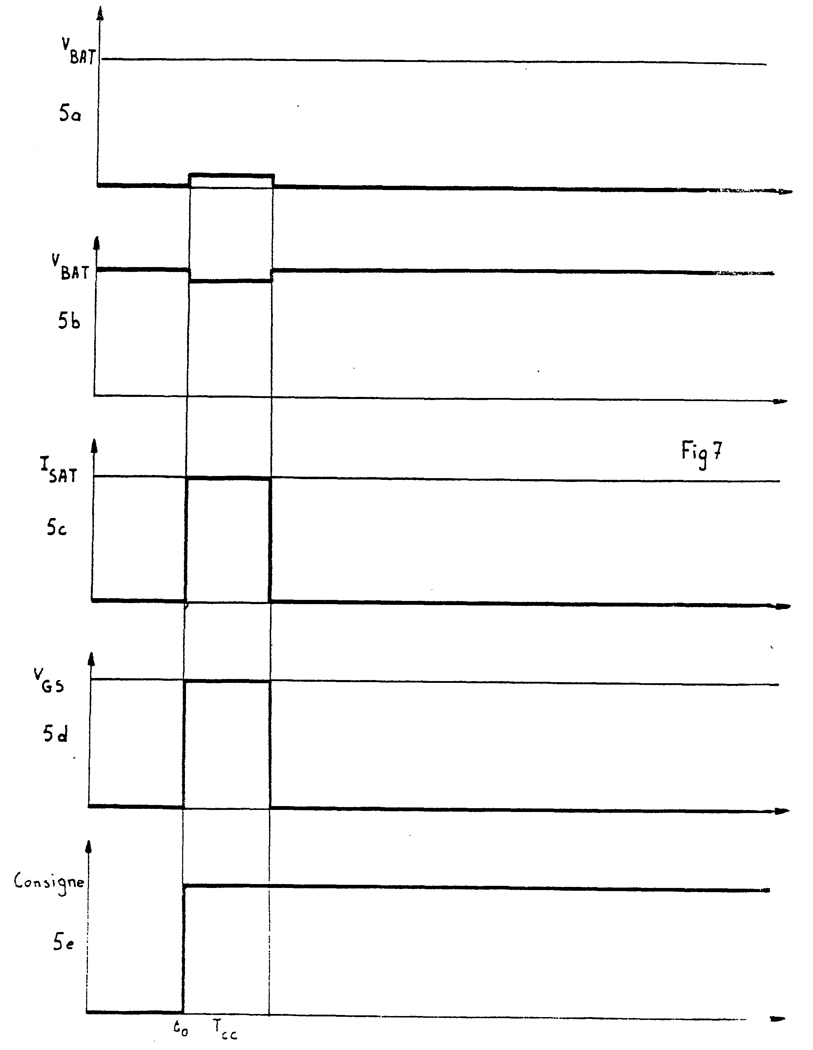

Dans le cas d'une coupure du circuit, le fonctionnement est illustré sur la figure 7.

On remarque :

5a : $V_L$ reste nulle
5b : $V_{DS}$ reste nulle
5c : $I_{DS}$ reste nul.

La coupure du circuit est détectée.

Bien entendu, l'ensemble peut comporter plusieurs circuits de surveillance du genre précité, en tête desquels un sélecteur de commande permet à l'utilisateur de choisir le circuit à tester. Sur un véhicule, ces circuits peuvent correspondre :

— l'un au contrôle des phares ;
— un autre au contrôle des veilleuses ;
— un autre encore au contrôle du circuit de charge de la batterie ;
— etc.

**Revendications**

1. Dispositif de commande, de contrôle et de sécurité pour des appareils électriques d'utilisation, notamment des appareils montés à bord d'un véhicule, comprenant au moins un circuit de surveillance qui groupe :

a) — une source de courant continu (BAT) ;

b) — un transistor de puissance, monté en série entre la source de courant et au moins l'un des appareils électriques d'utilisation ;

c) — une logique programmée pour tester périodiquement la conduction du transistor et la chute de tension dans la charge ;

d) — un système d'affichage, caractérisé en ce que la logique est un microprocesseur et le transistor de puissance un transistor MOS dont la grille est pilotée par le microprocesseur que le dispositif comprend des moyens ($E_p$) associés au microprocesseur pour mesurer la différence de potentiel drain-source dans le transistor MOS, la limitation d'intensité $I_{DS}$ à $I_{SAT}$ définie par le $V_{GS}$ de ce transistor MOS étant supérieure à la valeur correspondant à l'intensité nominale normale d'utilisation du ou des appareils électriques, $V_{GS}$ étant la tension de commande qui opère la limitation en courant et que le microprocesseur est programmé pour tester périodiquement la relation logique :

$$V_{GS} \neq 0$$

et

$$V_{DS} > 1/2 \, V_{BAT}$$

où :

— $V_{DS}$ est la chute de tension dans le transistor MOS ;
— $V_{BAT}$ est la tension nominale aux bornes de la source de courant, le fait que cette relation logique soit satisfaite étant considéré comme caractérisant l'existence d'un court-circuit dans l'installation.

2. Dispositif suivant la revendication 1, caractérisé en ce que $V_{GS} \neq 0$, et $V_{DS} = 0$, indiquent la coupure du circuit de l'installation à surveiller.

3. Dispositif suivant la revendication 1, caractérisé en ce que le microprocesseur est programmé pour interrompre périodiquement et pendant un temps très court, la tension $V_{GS}$ pour annuler la conduction du transistor MOS étant entendu que, si $V_{GS} = 0$, et si $V_{DS} > 1/2 \, V_{BAT}$, le circuit n'est pas coupé.

4. Dispositif suivant la revendication 1, caractérisé en ce que le microprocesseur est relié à au moins un voyant lumineux dont il déclenche l'éclairement dans les conditions suivantes :

— voyant éclairé de façon continue : fonctionnement normal du circuit ;

— voyant éclairé et clignotant rapidement : présence d'un court-circuit ;

— voyant éclairé et clignotant lentement : le circuit présente une coupure.

5. Dispositif suivant l'une quelconque des revendications précédentes, caractérisé en ce qu'il comprend plusieurs circuits de surveillance, groupés sous un sélecteur de commande manœuvré par l'utilisateur, pour lui permettre de choisir celui des circuits qu'il désire tester.

6. Dispositif suivant la revendication 5, caractérisé en ce que le sélecteur assure le choix entre l'un ou l'autre des circuits suivants, à vérifier sur un véhicule :

— phares ;

— éclairage « Code » ;

— veilleuses ;

— repos de l'ensemble de l'éclairage ;

— appel de phare ;

— clignotants de changement de direction ;

— circuit de charge de la batterie.

**Claims**

1. A control, monitoring and safety apparatus for electrical load devices, in particular devices mounted on board a vehicle, comprising at least one monitoring circuit which combines :

a) a direct current source (BAT) ;

b) a power transistor disposed in series between the current source and at least one of the electrical load devices ;

c) a programmed logic means for periodically testing conduction of the transistor and the voltage drop in the load ; and

d) a display system, characterised in that the logic means is a microprocessor and the power transistor an MOS transistor, the gate of which is pilot-controlled by the microprocessor, the apparatus comprises means (Ep) associated with the microprocessor to measure the drain-source potential difference in the MOS transistor, the limitation of strength $I_{DS}$ to $I_{SAT}$ defined by the $V_{GS}$ of the MOS transistor being higher than the value corresponding to the normal nominal strength of use of the electrical device or devices, $V_{GS}$ being the control voltage which effects the limitation in respect of current, and that the microprocessor is programmed for periodically testing the logic relationship :

$$V_{GS} \neq 0$$

and

$$V_{DS} > 1/2\ V_{BAT}$$

wherein :

— $V_{DS}$ is the voltage drop in the MOS transistor ; and

— $V_{BAT}$ is the nominal voltage at the terminals of the current source, the fact that that logic relationship is satisfied being considered as characterising the existence of a short-circuit in the installation.

2. Apparatus according to claim 1 characterised in that $V_{GS} \neq 0$ and $V_{DS} = 0$ indicate a cut in the circuit of the installation to be monitored.

3. Apparatus according to claim 1 characterised in that the microprocessor is programmed for periodically interrupting the voltage $V_{GS}$ for a very short time to nullify conduction of the MOS transistor, given that, if $V_{GS} = 0$ and if $V_{DS} > 1/2\ V_{BAT}$, the circuit is not cut.

4. Apparatus according to claim 1 characterised in that the microprocessor is connected to at least one light telltale, the illumination of which it triggers under the following conditions :

— telltale lit continuously : normal operation of the circuit ;

— telltale lit and flashing rapidly : presence of a short-circuit ;

— telltale lit and flashing slowly : the circuit has a break.

5. Apparatus according to any one of the preceding claims characterised in that it comprises a plurality of monitoring circuits grouped under a control selector which is operated by the user to permit him to choose that one of the circuits which he wants to test.

6. Apparatus according to claim 5, characterised in that the selector provides for a choice between one or other of the following circuits to be checked on a vehicle :

— headlights ;

— « dipped » lights ;

— sidelights ;

— rest condition of the whole of the lighting system ;

— headlight flashing ;

— direction-indication flashers ; and

— battery charging circuit.

## Patentansprüche

1. Gerät zur Steuerung und zur Sicherung elektrischer Gebrauchsapparate, insbesondere an Bord eines Kraftfahrzeuges, mit wenigstens einem Überwachungsnetz, das umfaßt :

a) eine Gleichstromquelle BAT,

b) einen Leistungstransistor, der in Serie zwischen der Stromquelle und wenigstens einem der elektrischen Gebrauchsapparate geschaltet ist,

c) einen programmierten logischen Schaltkreis, um periodisch die Leitfähigkeit des Transistors und den Spannungsabfall in der Last zu testen und

d) einen Anzeigeanordnung, dadurch gekennzeichnet, daß der logische Schaltkreis eine Mikroprozessor ist und daß der Leistungstransistor ein MOS-Transistor ist, dessen Gitter vom Mikroprozessor gesteuert wird, daß das Gerät eine Anordnung Ep aufweist, die mit dem Mikroprozessor verbunden ist, um die Potentialdifferenz zwischen Drain und Source im MOS-Transistor zu messen, wobei die Intensitätsbegrenzung $I_{DS}$ bis $I_{SAT}$, die durch $V_{GS}$ des MOS-Transistors definiert ist, größer als der entsprechende Wert der nominalen Intensität im normalen Einsatz des oder der elektrischen Apparate ist, wobei $V_{GS}$ die Steuerspannung ist, die die Strombegrenzung steuert und daß der Mikroprozessor derart programmiert ist, daß er periodisch die logische Beziehung testet :

$$V_{GS} \neq 0$$

und

$$V_{DS} > 1/2 \ V_{BAT}, \text{ wobei}$$

— $V_{DS}$ der Spannungsabfall im MOS-Transistor ist und

— $V_{BAT}$ die Nominalspannung an den Anschlüssen der Stromquelle ist und wobei die Tatsache, daß diese logische Beziehung erfüllt ist als Eigenheit angesehen wird, um das Vorhandensein eines Kurzschlusses in der Anlage nachzuweisen.

2. Gerät nach Anspruch 1, dadurch gekennzeichnet, daß $V_{GS} \neq 0$ und $V_{DS} = 0$ die Unterbrechung des Stromes in der zu überwachenden Anlage anzeigen.

3. Gerät nach Anspruch 1, dadurch gekennzeichnet, daß der Mikroprozessor derart programmiert ist, daß er periodisch während sehr kurzer Zeiten die Spannung $V_{DS}$ unterbricht, um die Leitfähigkeit des MOS-Transistors zu annulieren, wobei vorausgesetzt wird, daß wenn $V_{GS} = 0$ und wenn $V_{DS} > 1/2 \ V_{BAT}$ ist, der Stromkreis nicht unterbrochen ist.

4. Gerät nach Anspruch 1, dadurch gekennzeichnet, daß der Mikroprozessor mit wenigstens einer optischen Anzeige verbunden ist, deren Aufleuchten er auslöst unter den folgenden Bedingungen :

— kontinuierliches Aufleuchten der Anzeige : normale Funktionsweise der Schaltung

— Aufleuchten und schnelles Blinken der Anzeige : Vorhandensein eines Kurzschlusses

— Aufleuchten und langsames Blinken : die Schaltung weist eine Unterbrechung auf.

5. Gerät nach einem der vorhergehenden Ansprüche, dadurch gekennzeichnet, daß es mehrere Überwachungsnetze aufweist, die einem Steuerschalter zugeordnet sind, der vom Benutzer betätigbar ist, um ihm die Auswahl der Schaltkreise zu ermöglichen, die er testen möchte.

6. Gerät nach Anspruch 5, dadurch gekennzeichnet, daß der Wahlschalter die Auswahl des einen oder anderen der folgenden zu überprüfenden Schaltkreise ermöglicht :

— Scheinwerfer

— Abblendlicht

— Parklicht

— Ausgeschaltete Beleuchtungsanlage

— Lichthupe

— Blinker für die Fahrtrichtungsanzeige

— Ladeschaltung für die Batterie.

Fig 1

Fig 2

1

Fig 3

Fig 4

EP 0 080 425 B1

Fig 5

Fig 6

Fig 7

5